# EUROPEAN PATENT APPLICATION

(11) **EP 3 633 657 A1**
(43) Date of publication of application: **08.04.2020**
(21) Application number: 18810613.2
(22) Date of filing: 24.04.2018
(51) Int. Cl.: G09F 9/33, G02B 5/20, G02B 5/22, H01L 33/50

(54) **FULL-COLOR LED DISPLAY PANEL**

(30) Priority: 01.06.2017 JP 2017109156
(71) Applicant: V Technology Co., Ltd., Yokohama-shi, Kanagawa 240-0005 (JP)
(72) Inventor: KAJIYAMA, Koichi, Yokohama-shi Kanagawa 240-0005 (JP); HIRANO, Takafumi, Yokohama-shi Kanagawa 240-0005 (JP)
(74) Representative: HGF Limited
(86) International application number: PCT/JP2018/016592
(87) International publication number: WO 2018/221081

(57) **Abstract**

The present invention includes: an LED array substrate 1 in which multiple LEDs 3 are arranged in a matrix pattern on a substrate, each of the multiple LEDs emitting light in an ultraviolet to blue wavelength band; multiple fluorescent layers 5 arranged side by side above the multiple LEDs 3 in a manner corresponding to three primary colors of light, each fluorescent layer 5 being configured to perform wavelength conversion by being excited by excitation light emitted from a corresponding LED 3 and by emitting fluorescence having a corresponding color; and an excitation light blocking layer 8 disposed to cover the fluorescent layers 5, the excitation light blocking layer 8 being configured to block the excitation light.

## Description

### TECHNICAL FIELD

The present invention relates to full-color LED display panels, and more specifically, relates to full-color LED display panels that are easy to manufacture and are superior in color reproduction.

### BACKGROUND ART

A conventional full-color light-emitting diode (LED) display panel is configured to display images in full color by arranging LEDs of three colors, that is, red, green, and blue, as a set, in a dot matrix pattern (see, for example, Patent Document 1).

Another full-color LED display panel is provided with: an array of micro LED devices, each micro LED device emitting blue (e.g., 450 nm to 495 nm) light or deep blue (e.g., 420 nm to 450 nm) light; and an array of wavelength conversion layers disposed over the array of micro LED devices, each wavelength conversion layer absorbing the blue or deep blue light emitted from the corresponding micro LED device to convert the emission wavelength into the wavelengths of red, green, and blue light (see, for example, Patent Document 2).

### REFERENCE DOCUMENT LIST

### PATENT DOCUMENTS

Patent Document 1: JP 2012-145725 A
Patent Document 2: JP 2016-523450 A

### SUMMARY OF THE INVENTION

### PROBLEM TO BE SOLVED BY THE INVENTION

However, such a conventional full-color LED display panel disclosed in Patent Document 1 requires arrangement of red, green, and blue LEDs, in order. This results in problems of complicated manufacturing processes and higher manufacturing costs. In addition, since the emission wavelengths of the LEDs vary, it is difficult to improve the manufacturing yield. To deal with such problems, it is necessary to select LEDs before use. However, selecting LEDs before use may complicate manufacturing processes. Furthermore, since the emission color depends on the performances of LEDs, there have been problems in that tuning of emission colors is difficult, and color reproduction is poor.

Furthermore, in the conventional full-color LED display panel disclosed in Patent Document 2, there have been problems in that the emission color of light which has been subjected to wavelength conversion by the wavelength conversion layers, and blue or dark blue color of leaked light which has been emitted from the micro LED devices and then has been transmitted through the wavelength conversion layers are mixed, resulting in worse color reproduction. Furthermore, there has been additional problems in that, when the full-color LED display panel disclosed in Patent Document 2 is used outdoors, the wavelength conversion layers might be excited by blue or dark blue light in sunlight and thus might emit light, resulting in degraded color reproduction and contrast.

Therefore, in view of these problems, an object of the present invention is to provide a full-color LED display panel that is easy to manufacture and is superior in color reproduction.

### MEANS FOR SOLVING THE PROBLEM

To achieve the object, a full-color LED display panel according to the present invention includes: an LED array substrate in which multiple LEDs are arranged in a matrix pattern on a substrate, each of the multiple LEDs emitting light in an ultraviolet to blue wavelength band; multiple fluorescent layers arranged side by side above the multiple LEDs in a manner corresponding to three primary colors of light, each fluorescent layer being configured to perform wavelength conversion by being excited by excitation light emitted from a corresponding LED and by emitting fluorescence having a corresponding color; and an excitation light blocking layer disposed to cover the fluorescent layers, the excitation light blocking layer being configured to block the excitation light.

### EFFECTS OF THE INVENTION

According to the present invention, since LEDs of only a single type that emit light in the ultraviolet to blue wavelength band are disposed as light sources, it is possible to easily manufacture the full-color LED display panel. Moreover, since the excitation light blocking layer is disposed over the fluorescent layers, it is possible to prevent external light from reaching the fluorescent layers. Thus, it is possible to suppress the problem of degraded color reproduction caused by excitation and light emission of the fluorescent layers due to external light. Furthermore, since excitation light transmitted through the fluorescence layers, which is a part of the excitation light emitted from the LEDs, is reflected or absorbed by the excitation light blocking layer, it is possible to prevent the transmitted excitation light from leaking to the display surface. Therefore, it is also possible to prevent the problem of degraded color reproduction caused by mixing colors of the leaked excitation light and the fluorescence of the fluorescent layers.

### BRIEF DESCRIPTION OF THE DRAWINGS

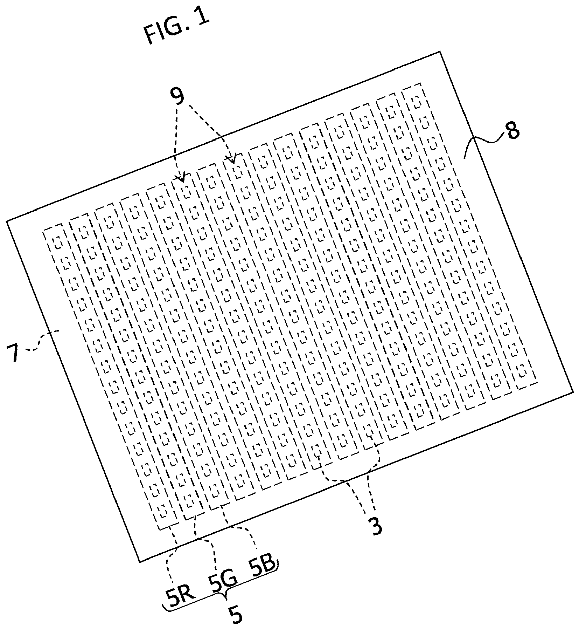

FIG. 1 is a plan view showing a first embodiment of a full-color LED display panel according to the present invention.

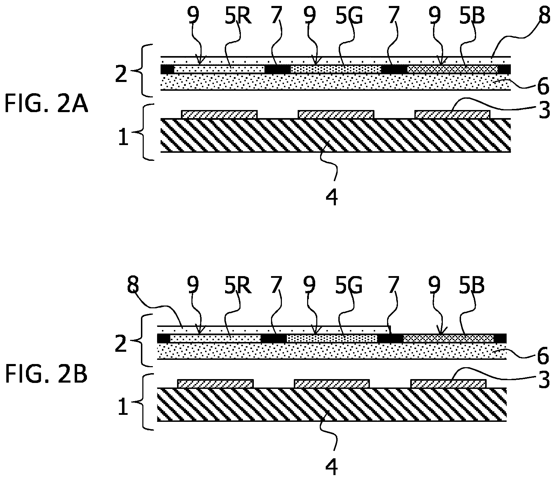

FIGS. 2A and 2B are enlarged cross-sectional views of the main part of FIG. 1, in which FIG. 2A shows an application example of an ultraviolet light blocking layer, serving as an excitation light blocking layer, and FIG. 2B shows an application example of a blue light blocking layer, serving as the excitation light blocking layer.

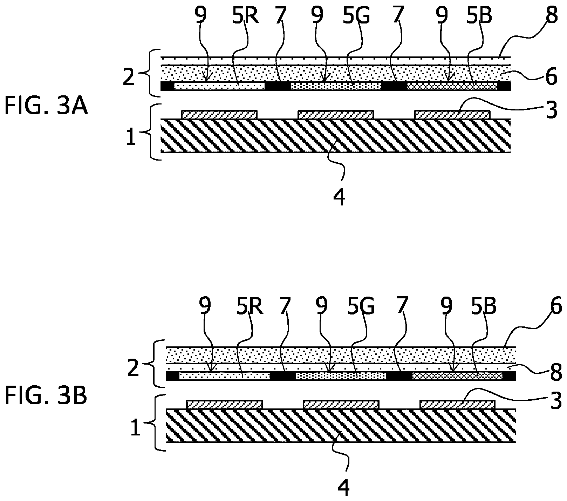

FIGS. 3A and 3B are enlarged cross-sectional views of the main part showing a second embodiment of a full-color LED display panel according to the present invention, in which FIG. 3A shows an example in which fluorescent layers are disposed facing LEDs, and an excitation light blocking layer is disposed on a display surface side of a transparent substrate of a fluorescent layer substrate, and FIG. 3B shows an example in which the excitation light blocking layer is disposed in the fluorescent layer substrate between the transparent substrate and the fluorescent layers.

### MODE FOR CARRYING OUT THE INVENTION

Hereinbelow, embodiments of the present invention will be described in detail with reference to the accompanying drawings. FIG. 1 is a plan view showing a first embodiment of a full-color LED display panel according to the present invention. FIGS. 2A and 2B are enlarged cross-sectional views of the main part of FIG. 1. The full-color LED display panel displays images in full color, and includes an LED array substrate 1 and a fluorescent layer substrate 2.

The LED array substrate 1 is provided with multiple LEDs 3 arranged in a matrix pattern, as shown in FIG. 1. In the LED array substrate 1, an LED array including the multiple LEDs 3 is disposed on a wiring board 4 that is provided with wiring for supplying drive signals to the LEDs 3 from an external drive circuit, and for individually driving the LEDs 3 to turn on and off.

Each LED 3 emits light in an ultraviolet to blue wavelength band, and is manufactured using gallium nitride (GaN) as a primary material. An LED 3 which emits a near-ultraviolet light having wavelengths of, for example, 200 nm to 380 nm, or an LED 3 which emits blue light having wavelengths of, for example, 380 nm to 500 nm, may be adopted.

On the LED array substrate 1, the fluorescent layer substrate 2 is disposed, as shown in FIGS. 2A and 2B. The fluorescent layer substrate 2 is provided with multiple fluorescent layers 5 arranged side by side. Each fluorescent layer 5 is configured to perform wavelength conversion by being excited by excitation light emitted from a corresponding LED 3 and by emitting fluorescence having a corresponding color. The fluorescent layer substrate 2 includes a transparent substrate 6, the fluorescent layers 5 for red, green and blue colors, a black matrix 7, and an excitation light blocking layer 8. As used herein, "up" always refers to a side of the display surface of the display panel, regardless of the installation state of the full-color LED display panel.

The transparent substrate 6 transmits at least light in a near-ultraviolet to blue wavelength band, and is made of a glass substrate or a plastic substrate, such as an acrylic resin.

The fluorescent layers 5 are disposed on one surface of the transparent substrate 6. The fluorescent layers 5 are red fluorescent layers 5R, green fluorescent layers 5G, and blue fluorescent layers 5B, which are arranged side by side above the LEDs 3 in a manner corresponding to the three primary colors of light, that is, red, green and blue. Each fluorescent layer 5 is a fluorescent resist containing a fluorescent colorant (pigment or dye) of a corresponding color. Although FIG. 1 shows a case in which the fluorescent layers 5 for red, green and blue colors are formed in a stripe shape, a fluorescent layer 5 may be provided above every LED 3 one by one.

Furthermore, the black matrix 7 is provided between and around the fluorescent layers 5 for red, green and blue colors. The black matrix 7 prevents leakage of light from the LEDs 3, prevents mixing of colors occurring between adjacent fluorescent layers 5, and prevents external light from being reflected on the panel surface and from reducing contrast. The black matrix 7 is a black resist that absorbs leaked light from adjacent LEDs 3 and external light. Alternatively, for example, the black matrix 7 may be formed by applying a paste containing a black pigment, or by depositing a metal oxide, such as chromium oxide.

The excitation light blocking layer 8 is disposed to cover the fluorescent layers 5. The excitation light blocking layer 8 selectively reflects or absorbs light in the same wavelength band as the excitation light, contained in external light, such as sunlight, to prevent the fluorescent layers 5 from being excited by such light and from emitting light, in order to improve color reproduction. Furthermore, since the excitation light blocking layer 8 also selectively reflects or absorbs excitation light transmitted through the red fluorescent layers 5R, the green fluorescent layers 5G, and the blue fluorescent layers 5B, which is a part of the excitation light emitted from the LEDs 3, the excitation light blocking layer 8 is provided to avoid the problem of degraded color reproduction, which might be caused by mixing colors of the transmitted excitation light and fluorescence emitted from the fluorescent layers 5.

When the excitation light is a near-ultraviolet light, an ultraviolet light blocking filter may be used as the excitation light blocking layer 8 and may be disposed to cover the fluorescent layers 5, as shown in FIG. 2A. Furthermore, when the excitation light is blue light, a blue light blocking filter with reduced transmission of the blue light may be used as the excitation light blocking layer 8, and may be disposed to cover the fluorescent layers 5, or may be disposed to cover the red and green fluorescent layers 5R and 5G, except for the fluorescent layers 5B, as shown in FIG. 2B.

Next, the manufacture of the full-color LED display panel having the above structure will be described.

First, a manufacturing process of the LED array substrate 1 will be described.

The multiple LEDs 3 emitting light in the near-ultraviolet to blue wavelength band are mounted at predetermined positions on the wiring board 4 provided with wiring for driving the multiple LEDs 3, in an electrically connected manner with the wiring, to prepare the LED array substrate 1.

Next, a manufacturing process of the fluorescent layer substrate 2 will be described.

First, after applying a black resist on the transparent substrate 6, the obtained substrate is exposed, using a photomask, and is then developed, to form the black matrix 7 with openings 9 in a stripe pattern at positions in which the fluorescent layers 5 are to be formed, as shown in FIG. 1, for example. Alternatively, the black matrix 7 may be formed by applying a paste containing a black pigment by inkjet printing, screen printing, or the like. Furthermore, a metal oxide, such as chromium oxide, may be deposited and may then be etched.

Next, a resist containing, for example, a red fluorescent colorant is applied to openings 9 of the black matrix 7 for, for example, the red fluorescent layers 5R by, for example, inkjet printing, and then the applied resist is cured by being irradiated with ultraviolet light, to form the red fluorescent layer 5R. Alternatively, a resist containing a red fluorescent colorant may be applied to cover the transparent substrate 6, and then, the applied resist may be exposed using a photomask, and may be developed, to form the red fluorescent layers 5R in openings 9 for the red fluorescent layers 5R.

Similarly, a resist containing, for example, a green fluorescent colorant is applied to openings 9 of the black matrix 7 for, for example, the green fluorescent layers 5G by, for example, inkjet printing, and then the applied resist is cured by being irradiated with ultraviolet light, to form the green fluorescent layers 5G. Alternatively, a resist containing a green fluorescent colorant and being applied to the entire upper surface of the black matrix 7 in a similar manner as described above may be exposed, using a photomask, and may then be developed, to form the green fluorescent layers 5G.

Similarly, a resist containing, for example, a blue fluorescent colorant, is applied to openings 9 of the black matrix 7 for, for example, the blue fluorescent layers 5B by, for example, inkjet printing, and then the applied resist is cured by being irradiated with ultraviolet light, to form the blue fluorescent layers 5B. Also in this case, a resist containing a blue fluorescent colorant and being applied to the entire upper surface of the black matrix 7 in a similar manner as described above may be exposed, using a photomask, and then may be developed, to form the blue fluorescent layers 5B.

Next, the excitation light blocking layer 8 is disposed to cover the fluorescent layers 5. In this case, when the excitation light emitted from the LEDs 3 to be used is near-ultraviolet light, an ultraviolet light blocking filter is used as the excitation light blocking layer 8, and is disposed to cover the red, green and blue fluorescent layers 5R, 5G, 5B, as shown in FIG. 2A. When the ultraviolet light blocking filter is a resin film, the film is attached so as to cover the red, green and blue fluorescent layers 5R, 5G, 5B. When the ultraviolet light blocking filter is a dielectric multilayer film, the film is deposited to cover the red, green and blue fluorescent layers 5R, 5G, 5B, by low temperature sputtering, or the like.

When the excitation light emitted from the LEDs 3 is blue light, a blue light blocking filter with reduced transmission of the blue light is used as the excitation light blocking layer 8. The blue light blocking filter is disposed to cover the fluorescent layers 5 as shown in FIG. 2A, or alternatively, is disposed to cover the red and green fluorescent layers 5R, 5G, except for the blue fluorescent layers 5B, as shown in FIG. 2B. The blue light blocking filter may be made of a film.

Subsequently, an assembly process of the LED array substrate 1 and the fluorescent layer substrate 2 will be described.

First, in a state in which an LED 3-side surface of the LED array substrate 1 and the transparent substrate 6-side surface of the fluorescent layer substrate 2 face each other, both substrates are aligned using alignment marks provided in advance on each substrate. Then, the red, green and blue fluorescent layers 5R, 5G, 5B provided on the fluorescent layer substrate 2 are positioned with respect to the LEDs 3 for red, green and blue colors provided on the LED array substrate 1, respectively.

Then, while maintaining the aligned state, the LED array substrate 1 and the fluorescent layer substrate 2 are bonded using an adhesive, or the like, to form the full-color LED display panel.

FIGS. 3A and 3B are enlarged cross-sectional views of the main part showing a second embodiment of the full-color LED display panel according to the present invention. The LED array substrate 1 and the fluorescent layer substrate 2 may be bonded while the LED 3-side surface of the LED array substrate 1 and the fluorescent layer 5-side surface of the fluorescent layer substrate 2 face each other. In this case, as shown in FIG. 3A, the excitation light blocking layer 8 is disposed on a surface of the transparent substrate 6 opposite to the surface on which the fluorescent layers 5 are formed. Alternatively, the excitation light blocking layer 8 may be disposed between the transparent substrate 6, and the fluorescent layers 5 and the black matrix 7, as shown in FIG. 3B.

Although FIGS. 3A and 3B show cases in which the excitation light blocking layer 8 is disposed to cover all of the fluorescent layers 5, it may be preferable that the blue light blocking filter is formed in a region excluding a portion corresponding to the blue fluorescent layers 5B, when the blue light blocking filter is used as the excitation light blocking layer 8, similarly to FIG. 2B.

According to the full-color LED display panel of the present invention, since the LEDs 3 of only a single type, such as LEDs that emit light in the near-ultraviolet to blue wavelength band, or near-ultraviolet light emitting LEDs or blue light emitting LEDs, are disposed as light sources, it is possible to easily manufacture the full-color LED display panel.

Furthermore, even if the emission wavelengths of the LEDs 3 vary, the display color is hardly affected by the variations in emission wavelength of the LEDs 3, because the emitted light of the LEDs 3 is subjected to the wavelength conversion by the fluorescent layers 5 to obtain fluorescence with desired colors. Thus, it is possible to display images in full color with superior color reproduction. Therefore, it is possible to eliminate the selecting process of LEDs 3 performed in the conventional technique, and this also makes the full-color LED display panel easy to manufacture.

Furthermore, since there are many more types of fluorescent colorants (pigments or dyes) for the fluorescent layers 5 than there are types of LEDs 3, there are many choices for fluorescent colors based on the relationship between the excitation light wavelength and the fluorescence wavelength. Therefore, it is possible to easily tune colors.

According to the present invention, since the excitation light blocking layer 8 is disposed over the fluorescent layers 5, it is possible to prevent external light from reaching the fluorescent layers 5. Thus, it is possible to suppress the problem of degraded color reproduction caused by excitation and light emission of the fluorescent layers 5 due to external light. Furthermore, since excitation light transmitted through the fluorescence layers 5, which is a part of the excitation light emitted from the LEDs 3, are reflected or absorbed by the excitation light blocking layer 8, it is possible to prevent the transmitted excitation light from leaking to the display surface. Therefore, it is also possible to prevent the problem of degraded color reproduction caused by mixing colors of the leaked excitation light and the fluorescence of the fluorescent layers 5.

### REFERENCE SYMBOL LIST

- 1: LED array substrate
- 3: LEDs
- 4: Wiring board (board)
- 5: Fluorescent layers
- 5R: Red fluorescent layer
- 5G: Green fluorescent layer
- 5B: Blue fluorescent layer
- 7: Black matrix
- 8: Excitation light blocking layer

## Claims

1. A full-color LED display panel comprising:
an LED array substrate in which multiple LEDs are arranged in a matrix pattern on a substrate, each of the multiple LEDs emitting light in an ultraviolet to blue wavelength band;
multiple fluorescent layers arranged side by side above the multiple LEDs in a manner corresponding to three primary colors of light, each fluorescent layer being configured to perform wavelength conversion by being excited by excitation light emitted from a corresponding LED and by emitting fluorescence having a corresponding color; and
an excitation light blocking layer disposed to cover the fluorescent layers, the excitation light blocking layer being configured to block the excitation light.

2. The full-color LED display panel according to claim 1, wherein a black matrix is disposed at least between the fluorescent layers for the three primary colors.

3. The full-color LED display panel according to claim 1 or 2, wherein each of the fluorescent layers is a fluorescent resist containing a fluorescent colorant of a corresponding color.

4. The full-color LED display panel according to claim 1 or 2, wherein, when the excitation light is an ultraviolet light, the excitation light blocking layer is an ultraviolet light blocking filter and is disposed to cover the fluorescent layers.

5. The full-color LED display panel according to claim 3, wherein, when the excitation light is an ultraviolet light, the excitation light blocking layer is an ultraviolet light blocking filter and is disposed to cover the fluorescent layers.

6. The full-color LED display panel according to claim 1 or 2, wherein, when the excitation light is blue light, the excitation light blocking layer is a blue light blocking filter with reduced transmission of blue light, and is disposed to cover the fluorescence layers, or to cover fluorescent layers for red and green, except for fluorescent layers for blue.

7. The full-color LED display panel according to claim 3, wherein, when the excitation light is blue light, the excitation light blocking layer is a blue light blocking filter with reduced transmission of blue light, and is disposed to cover the fluorescence layers, or to cover fluorescent layers for red and green, except for fluorescent layers for blue.
